# EUROPEAN PATENT SPECIFICATION

(11) **EP 0 357 982 B1**
(45) Date of publication and mention of the grant of the patent: **01.03.1995**
(21) Application number: 89114653.2
(22) Date of filing: 08.08.1989
(51) Int. Cl.: G11C 5/00, G11C 11/412, H03K 3/356

(54) **Memory cell with improved single event upset rate reduction circuitry**
Speicherzelle mit einer Schaltung zur Reduzierung von Unordnungseinzelereignissen
Cellule de mémoire ayant un circuit de réduction de faux d'évènements uniques de dérangement

(30) Priority: 07.09.1988 US 241524; 07.09.1988 US 241681; 30.09.1988 US 252200
(43) Date of publication of application: 14.03.1990
(73) Proprietor: TEXAS INSTRUMENTS INCORPORATED, Dallas Texas 75265 (US)
(72) Inventor: Blake, Terence G. W., Dallas Texas 75243 (US); Houston, Theodore W., Richardson Texas 75080 (US)
(74) Representative: Leiser, Gottfried, Dipl.-Ing.

(56) References cited:
- GB-A- 1 163 788
- IEEE TRANSACTIONS ON NUCLEAR SCIENCE, vol. 34, no. 6, part 1, December 1987,pages 1281-1286, New York, US; H. WEAVER et al.: "An seu tolerant memory cellfrom fundamental studies of seu mechanisme in SRAM"
- PROCEEDINGS OF THE 1987 BIPOLAR CIRCUITS AND TECHNOLOGY MEETING, 21st - 22nd
- September 1987, pages 50-53, New York, US; R. GAVROK et al.: "Logic-family andmemory-cell designs providings abrupt voltage transitions and high noisemargins"

## Description

The invention relates to a bi-stable logic device comprising a set of cross-coupled inverters, said set of inverters including first and second inverters.

The susceptability of integrated circuit memories to soft error or single event upset (SEU) is of particular concern in space. See E. G. Muller, M. S. Gussenhower, K. A. Lynch and D. H. Brenteger, "DMSP Dosimetry Data: A Space Measurement and Mapping of Upset Causing Phenomena". IEEE Trans. Nuclear Science NS-34, pp. 1251-1255 (1987) and H. T. Weaver, et al., "An SEU Tolerant Memory Cell Derived from Fundamental Studies of SEU Mechanisms in SRAM", IEEE Trans. Nuclear Science, NS-34, pp. 1281-1286 (1987). A soft error or single event upset typically is caused by electron-hole pairs created by, and along the path of, a single energetic particle as it passes through an integrated circuit, such as a memory. Should the energetic particle generate the critical charge in the critical volume of a memory cell, then the logic state of the memory is upset. This critical charge, by definition, is the minimum amount of electrical charge required to change the logic state of the memory cell. The critical charge may also enter the memory through direct ionization from cosmic rays. See T. C. May and M. H. Woods, "Alpha Particle Induced Soft Errors in Dynamic Memories", IEEE Trans. Electronic Devices, ED-26, p. 2 (1979) and J. C. Pickel, J. T. Blaudfood, Jr., "CMOS RAM Cosmic Ray - Induced Error Rate Analysis" IEEE Trans. on Nuclear Science, Vol. NS-28, pp. 3962-3967 (1981). Alternatively, the critical charge may result from alpha particles (helium nuclei). One example of SEU can be seen in figure 1a which illustrates a cross-sectional view of a CMOS inverter. When alpha particle p strikes bulk semiconductor material in p-channel MOS transistor Pch, it generates electron-hole pairs as shown by the respective minus and plus marks. Assuming that n-channel transistor Nch is on and that p-channel transistor Pch is off, the holes (represented by + signs) which collect (see arrows toward drain D) at drain D can change the voltage at output OUT from a logic low to a logic high. The electrons as indicated by the minus signs will diffuse toward circuit supply voltage Vcc. A charge generating energetic particle hit on transistor Nch has the opposite effect with positive charges drifting towards ground and negative charges collecting at output OUT, thus possibly changing the logic state of the inverter with its n-channel transistor off and its p-channel transistor on.

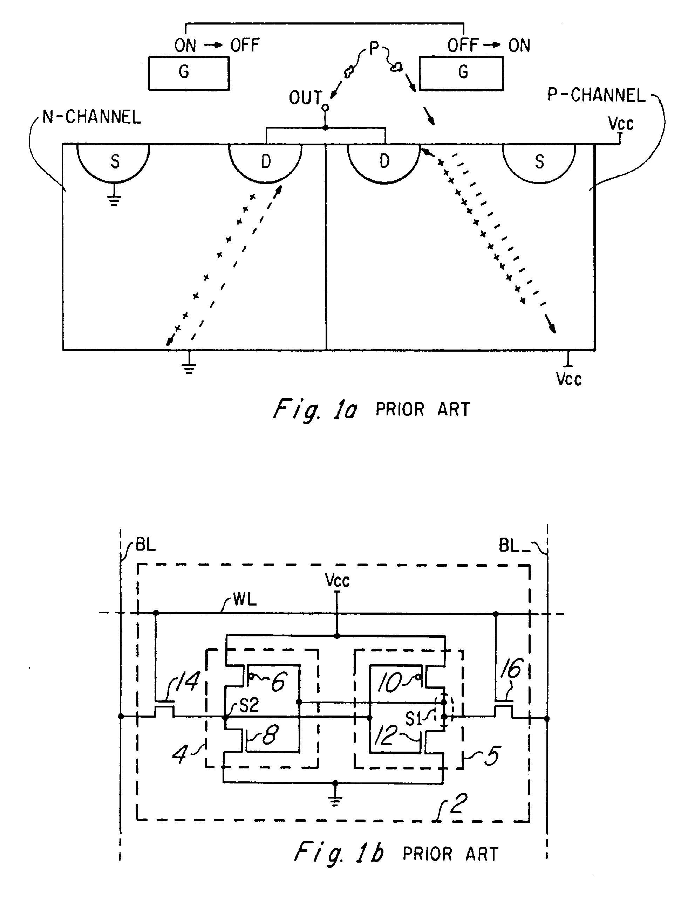

Further background follows with reference to figure 1b which illustrates a schematic drawing of a conventional CMOS (complementary metal oxide semiconductor) static memory cell, typically used in a static random access memory (SRAM). (Note that the term metal used in the pharse metal oxide semiconductor is interpreted in semiconductor and related arts as also encompassing polycrystalline semiconductor material.) Memory cell 2 is constructed according to well known methods of cross-coupled inverter realization and thus CMOS inverters are used in memory cell 2. A first CMOS inverter 4 in memory cell 2 comprises p-channel transistor 6 and n-channel transistor 8 having their source-to-drain paths connected in series between voltage Vcc and ground, and having their gates tied together. The second CMOS inverter 5 in memory cell 2 is similarly constructed, with p-channel transistor 10 and n-channel transistor 12 having their source-to-drain paths connected in series between Vcc and ground and their gates also common. The cross-coupling is accomplished by the gates of transistors 6 and 8 being connected to the drains of transistors 10 and 12 (node S1 of figure 1b), and by the gates of transistors 10 and 12 being connected to the drains of transistors 6 and 8 (node S2 of figure 1b). N-channel pass transistor 14 has its source-to-drain path connected between node S2 and a first bit line BL, and has its gate connected to word line WL. N-channel pass transistor 16 similarly has its source-to-drain path connected between node S1 and a second bit line BL_ , and has its gate also connected to word line WL. Pass transistors 14, 16 when enabled, allow data to pass into and out of memory cell 2 from bit lines BL and BL_ respectively. Bit lines BL and BL_ carry data into and out of memory cell 2. Pass transistors 14, 16 are enabled by word line WL which is a function of the row address in an SRAM. The row address is decoded by a row decoder in the SRAM such that one out of n word lines is enabled, where n is the number of rows of memory cells in the memory, which is a function of memory density and architecture.

In operation, the voltages of node S1 and S2 will necessarily be logical complements of one another, due to the cross-coupled nature of CMOS inverters 4, 5 within memory cell 2. When word line WL is energized by the row decoder (not shown), according to the row address received at address inputs to an address buffer (not shown) connected to the row decoder, pass transistors 14 and 16 will be turned on, coupling nodes S1 and S2 to bit lines BL_ and BL, respectively. Accordingly, when word line WL is high, the state of memory cell 2 can establish a differential voltage on BL and BL_. Alternatively, peripheral circuitry forcing a voltage on BL and BL_ can alter the state of memory cell 2. The sizes of the transistors shown in figure 1b are generally chosen such that when pass transistors 14 and 16 are turned on by word line WL; a differentially low voltage at bit line BL with respect to node S2 can force node S2 to a logic low level; and a differentially low voltage at bit line BL_ with respect to node S1 can force node S1 to a logic low level. However, the sizes of the transistors shown in figure 1 are also chosen such that when transistors 14 and 16 are on; a differentially high voltage at bit line BL with respect to node S2 will not force node S2 high; nor will a differentially high voltage at bit line BL_ with respect to node S1 force node S1 high. Therefore writing into memory cell 2 is accomplished by pulling the desired bit line and thus the desired side of cell 2 at either node S1 or node S2 low, which in turn due to feedback paths in cell 2, causes the opposite side of cell 2 to have a logic high state.

One method for hardening a memory cell against SEU is by reducing the amount of charge generated by a given event. This is accomplished for example, by using a silicon film thinner than the collection depth in bulk material. For instance, a memory cell created on a thin film of semiconductor, such as in an SOI (silicon on insulator)device, is less susceptible to SEU than one created on bulk semiconductor, such as silicon, because ionization charge along a path in an insulator is more likely to recombine than be collected compared to ionization charge created in a semiconductor.

Another way to reduce the susceptibility of a memory cell to upset is by increasing the critical charge of the cell.

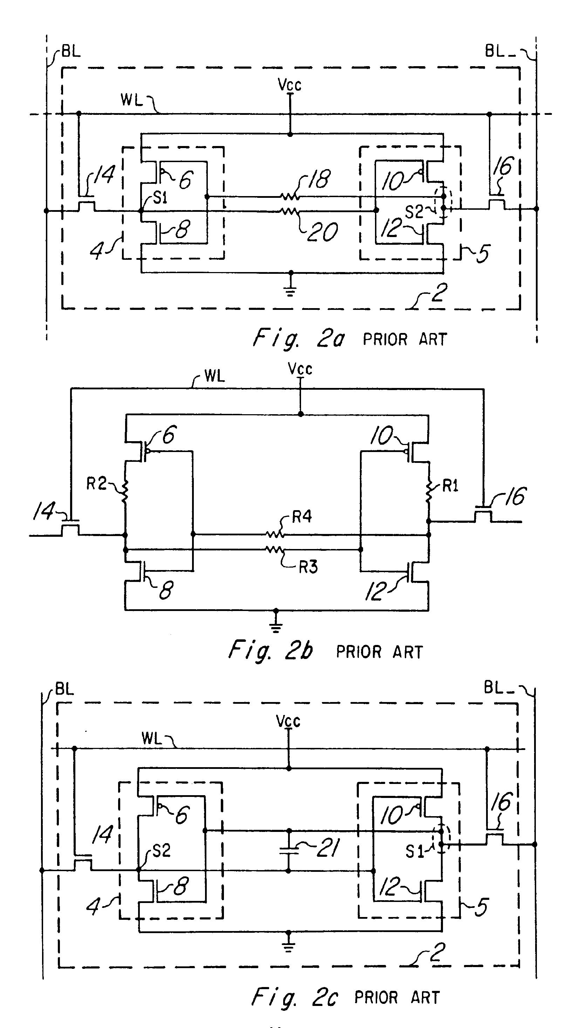

A hardening scheme against SEU in static memory cells based on increasing the critical charge required to produce SEU is illustrated in the schematic drawing of figure 2a. As shown, resistors 18 and 20 are included in the cross-coupling lines of inverters 4 and 5 and they increase the RC time constant delay associated with the gate capacitances of transistors 6, 8, 10, and 12. The initial effect of an energetic particle strike in a critical volume is to change the voltage of one node of the memory cell, say node S1. Upset will occur if this change in voltage propagates through the cross coupling of inverters 4 and 5 before the initial voltage of node S1 is restored. The increased RC delay slows the feedback propagation through the cross coupling and allows more time for recovery of the initially affected node. However, this increase in RC propagation delay also slows the write cycle time of cell 2. The write cycle of a static memory cell in a static random access memory (SRAM) has typically been faster than the read cycle so that some slowing of the write cycle has been acceptable, since the read cycle time was the most critical. However, with scaling of memory cells to small geometries, the speed of the write cycle of SEU hardened cells has become critical. Weaver, op. cit. introduced resistors R1 and R2 to protect against hits on the p-channel transistors 6 and 10 of his inverters as shown in the schematic drawing of figure 2b which illustrates the Weaver SEU reduction scheme. However, resistors R3 and R4 are still needed to protect against hits on n-channel transistors 8 and 12 ,thus limiting the WRITE speed of Weaver's memory cell. Therefore, this resistive approach to SEU hardening is no longer desirable.

Another hardening scheme against SEU based on increasing the critical charge is to increase the capacitance on the inverter drains, thus decreasing the voltage change on the node for a given amount of collected charge. The effectiveness of the capacitance in increasing the critical charge for SEU is increased by having the capacitance between the drains of the two inverters, which, with the cross coupling, is the same as between the gate and drain of the same inverter, as shown in figure 2c. Figure 2c illustrates the same circuit schematic as figure 1b with the exception that capacitor 21 is connected across the drains of the transistors of inverters S1 and S2. By having the capacitance between the gate and drain of the inverter, the effect of the capacitance is increased by Miller capacitance. Also, with the capacitance from gate to drain, a change in the drain voltage induces a change in the gate voltage such that the restoring current is increased. Increased capacitance on the gate will also increase the RC delay in the feed back path, thus increasing resistance to SEU and also slowing the write; however, so long as the resistance in the cross-coupling is small, this effect will be minimal. Thus, capacitor 21 can reduce the rate of SEU. However, two constraints must be met. First, capacitor 21 must be small in size in order to meet small circuit geometry requirements. Second, the capacitance of capacitor 21 must be maintained at a certain level in order to insure sufficient SEU hardening. As the level of memory density increases, the need is ever heightened for increased capacitance within the small circuit geometry constraint.

### OBJECTS OF THE INVENTION

It is an object of the invention to provide a new and improved memory cell.

It is another object of the invention to provide an new and improved memory cell for use in a static random access memory.

It is another object of the invention to provide a new and improved memory cell having increased hardness against single event upset.

The objects of the invention, together with the features and advantages thereof, will become apparent from the detailed specification when read together with the accompanying drawings in which applicable reference numerals have been carried forward.

### SUMMARY OF THE INVENTION

The foregoing objects of the invention are accomplished by a bi-stable logic device having the features contained in the characterizing part of claim 1.

### BRIEF DESCRIPTION OF THE DRAWINGS

Figure 1a illustrates a cross-sectional view of a CMOS inverter.

Figure 1b is a schematic drawing illustrating a conventional CMOS static memory cell.

Figure 2a is a schematic drawing illustrating a hardening scheme against SEU in static memory cells based on increasing the cricital charge required to produce SEU.

Figures 2b and 2c illustrate prior art hardening schemes against SEU in static memory cells.

Figure 3a is a schematic drawing illustrating a first preferred embodiment of the invention.

Figure 3b is a schematic drawing illustrating a second preferred embodiment of the invention.

Figure 3c is a schematic drawing illustrating a third preferred embodiment of the invention.

Figure 3d is a schematic drawing illustrating a fourth preferred embodiment of the invention.

Figure 3e is a schematic drawing illustrating a fifth preferred embodiment of the invention.

Figure 3f is a schematic drawing illustrating a sixth preferred embodiment of the invention.

Figure 4a is a schematic drawing illustrating a seventh preferred embodiment of the invention.

Figure 4b is a schematic drawing illustrating an eighty preferred embodiment of the invention.

Figure 4c illustrates the relative positions of a plurality of superimposed photolithographic mask portions used to possibly construct the circuit of figure 4b.

Figure 4d is a schematic drawing illustrating a tenth preferred embodiment of the invention.

Figure 5a is a schematic drawing illustrating an eleventh preferred embodiment of the invention.

Figure 5b is a schematic drawing illustrating a twelfth preferred embodiment of the invention.

Figure 6a illustrates a top view of the gated diode structure of transistor 22.

Figure 6b is a cross sectional view of transistors 22 and 24 illustrating heavily doped n-type regions n+.

Figure 7 illustrates a thirteenth preferred embodiment of the invention.

Figure 8 illustrates the superposition of a plurality of portions of photolithographic masks.

Figure 9a is a cross-sectional view of the transistor structure illustrating a silicon 52 on insulator 54 structure.

Figure 9b is a cross-sectional view of the transistor structure illustrating an etched mesa.

Figures 9c-9e illustration additional cross-sectional views of the transistor structure.

Figure 10a is a schematic drawing illustrating a fourtheenth preferred embodiment of the invention.

Figure 10b is a schematic drawing illustrating a fifteenth preferred embodiment of the invention.

Figure 10c is a schematic diagram illustrating a sixteenth preferred embodiment of the invention.

Figure 11 illustrates portions of superimposed photolithographic masks.

### DETAILED DESCRIPTION OF THE INVENTION

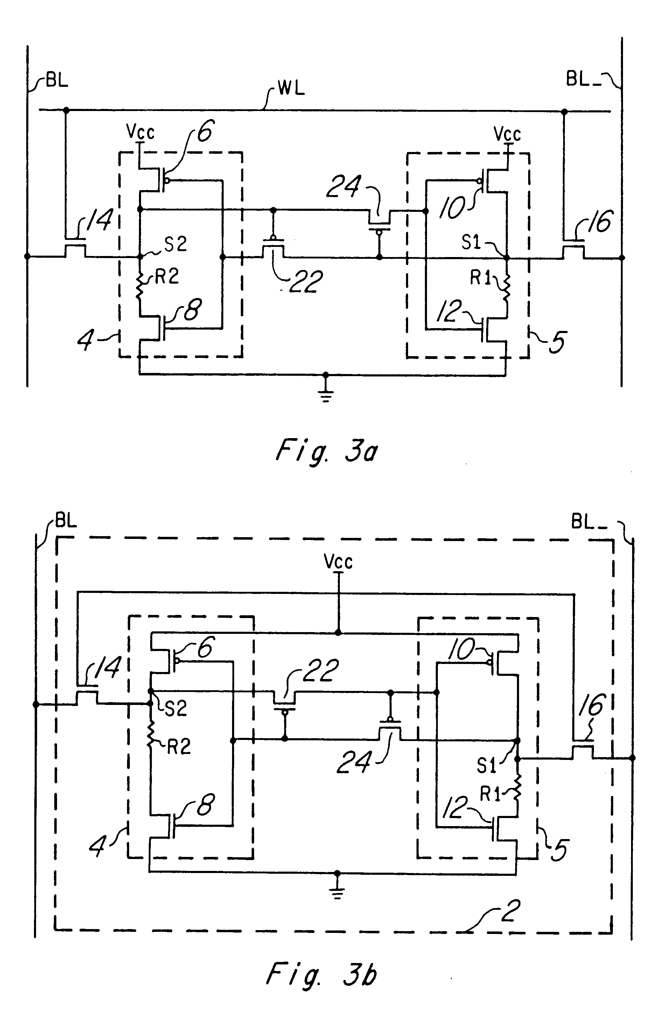

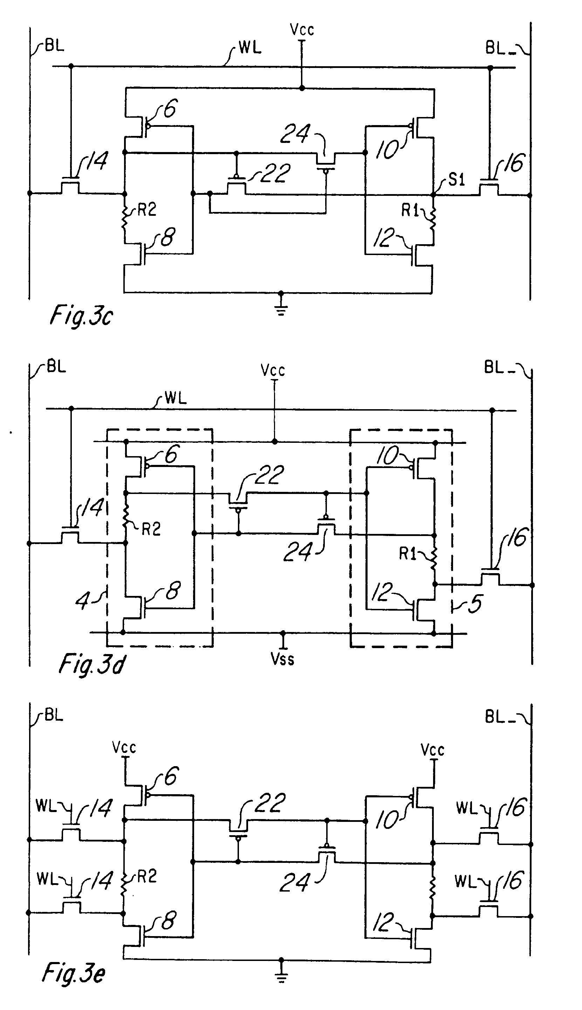

The first preferred embodiment of the invention places active devices, such as a pair of p-channel transistors (preferably metal oxide semiconductor (MOS) transistors in order to fit compactly and conserve space in a memory cell) in the cross coupling of a memory cell. A schematic drawing of an integrated circuit which includes a first preferred embodiment of the invention is illustrated in figure 3a. Note that for optimum SEU hardness that this circuit is built on an insulator body (although it can be built on bulk semiconductor material) and therefore can be classified as an SOI device. However, in a bulk embodiment, particular benefit is obtained if at least the devices in the cross-coupling are isolated from the bulk as could be done with stacked polysilicon transistors. Figure 3a illustrates the same circuit schematic as shown in figure 1b with the exception that p-channel transistors 22 and 24 are connected across an associated cross-coupling line joining a gate of one inverter to the drain of another. The gate of transistor 22 is connected to a source/drain of transistor 24 and the gate of transistor 24 is connected to the source/drain of transistor 22. Further, resistor R1 is connected to and between node S1 and the drain of transistor 12. Additionally, resistor R2 is connected to and between the node S2 and the drain of transistor 8.

Demonstration of the operation of the circuit in figure 3a shall be shown by example. The p-channel nature of transistors 22, 24 increases their conductance with negative gate to source voltage and therefore the feedback mechanism for writing into the memory cell is not slowed significantly. For the case where node S1 is initially logic high and node S2 is initially logic low, when attempting to write the opposite state into memory cell 2, node S1 must first be pulled to logic low. This logic low transition must be transmitted through transistor 22 which is in its most turned on state, to the common gate of transistors 6 and 8. Node S2 then changes from its initial logic low state to a logic high state in response to a low voltage at the gates of transistors 6 and 8. However, the transition of node S2 from low to high is transmitted through transistor 24, the gate of which is now at a voltage causing transistor 24 to be in a higher conducting state (logic low). Note that while the WRITE is accomplished through transistors 22 and 24 in their most turned on state, the voltage maintaining feedback in memory cell 2 must always go through transistors 22 and 24, one of which is always in a lower conducting state (gate high). This feedback can alternatively be maintained by leakage or subthreshold current, meaning that enhancement mode transistors or depletion mode transistors can be used as transistors 22 and 24.

If transistors 6 or 10 are hit by a particle which changes the logic state at the output of an inverter, memory cell 2 is able to recover from the hit due primarily to the added resistance provided in the cross-coupling by the resistive paths between source and drain regions of transistors 22 and 24 when each is in its lower conducting state. The effect of the added resistance increases the RC time constant delay, therefore allowing more time for recovery before the negative effect of the SEU induced voltage change propagates through memory cell 2. Resistors R1 and R2 provide resistive barriers to limit the amount of voltage drop occurring at nodes S2 and S1 resulting from a sufficiently charged hit on n-channel transistors 8 and 12 respectively. Although the capacitance and resistance provided by transistors 22 and 24 reduce the rate of SEU caused by hits on n-channel transistors 8,12 to some degree, resistors R1 and R2 account for significant reduction in SEU than would have resulted in a circuit without resistors R1 and R2 due to a hit on n-channel transistors 8 and 12.

Figure 3b illustrates a schematic drawing of a second preferred embodiment of the invention. This circuit may be viewed as the same circuit shown in figure 3a with the transistor 22 and 24 exchanged in position and numerical label with one another. The discussion of the operation of the circuit in figure 3a applies completely to the operation of the circuit in figure 3b by substituting transistor labels "22" with "24" and "24" with "22".

A third preferred embodiment of the invention connects the gate of transistor 24 to the input of inverter 4 as illustrated in figure 3c.

A fourth preferred embodiment of the invention is illustrated in the schematic drawing of figure 3d. Figure 3d is the same as figure 3b except that pass transistors 14 and 16 have a drain/source connected to the drain of the n-channel transistor of an inverter instead of the drain of the p-channel transistor of an inverter as shown in figures 3a and 3b. Alternatively, the n-channel drain connection can be applied to the circuit illustrated in figure 3a. The result of these embodiments is a faster READ operation (than when using a p-channel drain connection) but a slower WRITE operation (than when using a p-channel drain connection).

A fifth preferred embodiment of the invention is shown in the schematic drawing of figure 3e. This figure is similar to figure 3b except that it has two pass transistors on each side of the cell with a drain/source of one pass transistor on a side connected to the drain of the p-channel inverter transistor and the drain/source of the other pass transistor on the same side of the cell connected to the drain of the n-channel inverter transistor. This embodiment allows both a fast READ and a fast WRITE. Both pass transistors on a side of the cell can be turned on for both READ and WRITE. Alternatively, separate READ and WRITE word lines which turn on the pass transistors could be used. All of the above additions can likewise apply to the circuit shown in figure 3a.

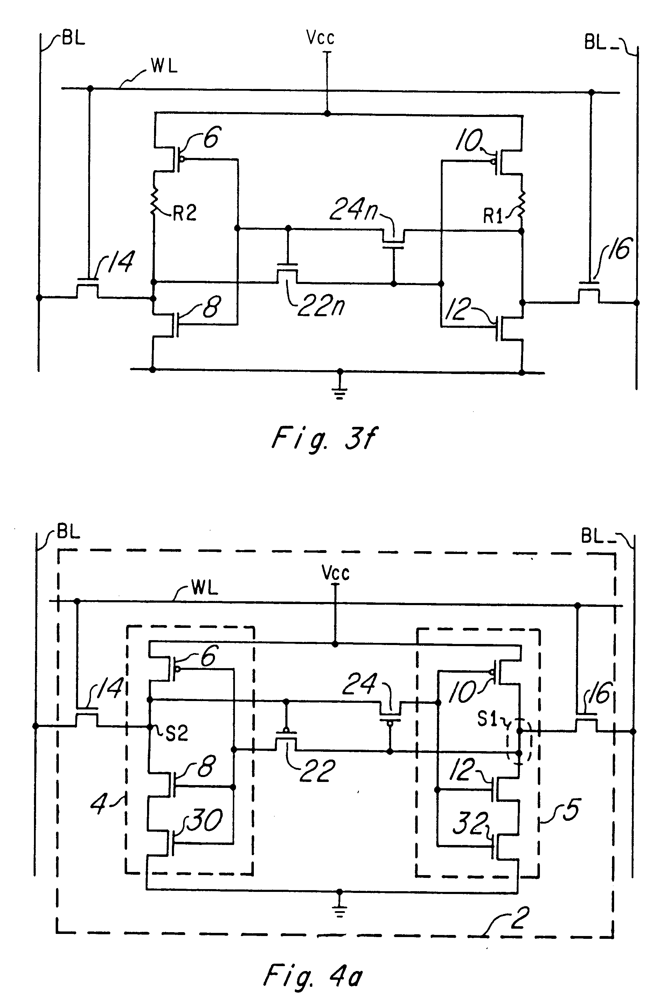

A sixth preferred embodiment of the invention is illustrated in the schematic drawing of figure 3f. This drawing is the same as that shown in figure 3a with the exception that n-channel transistors 22n and 24n have been substituted for p-channel transistors 22 and 24 respectively. Here, n-channel transistors 22n and 24n protect against a hit on n-channel transistors 8 and 12 while resistors R1 and R2 protect against a hit on p-channel transistors 6 and 10. This circuit has its greatest benefit when WRITE is accomplished by pulling the low side high.

A seventh preferred embodiment of the invention is illustrated in the schematic drawing of figure 4a. Figure 4a is the same as that shown in figure 3b except that n-channel transistor 30 has been added and resistor R2 has been eliminated. The gate of transistor 30 is common with the gates of transistors 6 and 8. Additionally, n-channel transistor 32 has been added and resistor R1 has been eliminated. The gate of transistor 32 is common with the gates of transistors 10 and 12. Increased protection from single event upset caused primarily by an energetic particle hit on the n-channel devices is provided since there is a low probability of a simultaneous hit on both n-channel transistors in a single inverter 4 or 5.

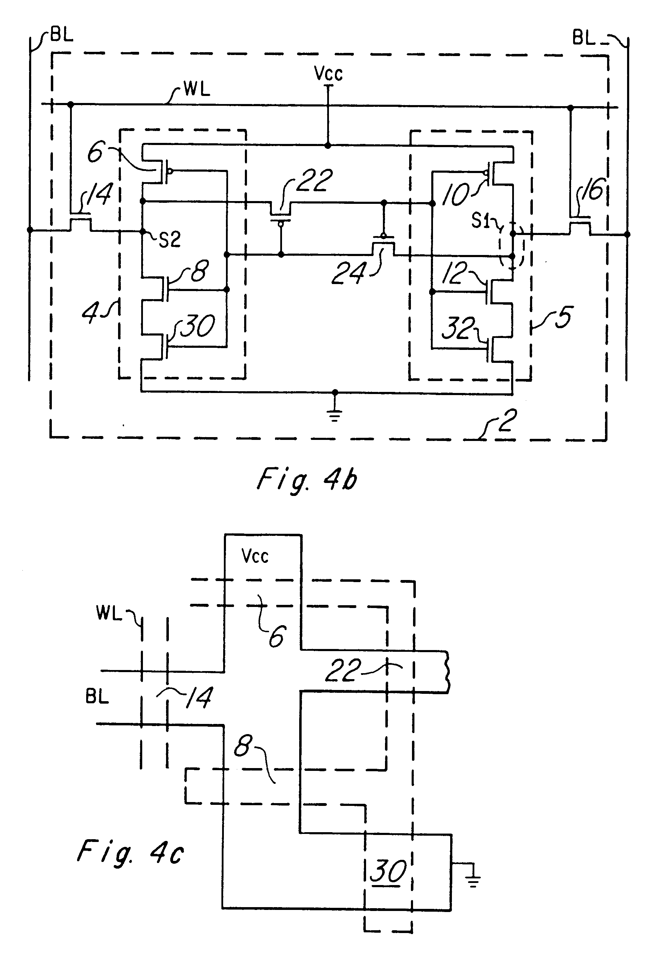

Figure 4b illustrates a schematic drawing of an eighth preferred embodiment of the invention. This circuit may be viewed as the same circuit shown in figure 4a with the transistors 22 and 24 exchanged in position and numerical label with one another. The discussion of the operation of the circuit in figure 4a applies substantially to the operation of the circuit in figure 4b by exchanging transistor labels "22" with "24" and "24" with "22".

In a ninth preferred embodiment of the invention to that shown in Figure 4a, the gate of transistor 24 can be connected to the input of inverter 4 rather than to both a drain/source of transistor 22 and the input of inverter 5.

The likelihood of SEU is further reduced, in the embodiment shown in Figures 4a and 4b, by spatially separating transistor 8 from transistor 30 and by spatially separating transistor 10 from transistor 32. One possible way of doing this is shown in figure 4c which illustrates the relative positions of a plurality of superimposed photolithographic mask portions used to possibly construct the circuit whose schematic is shown in figure 4b. Figure 4c illustrate the positions of elements on the left half of figure 4b. The common gates of transistors 22, 6, 8, and 30 are shown as dashed lines and the labels of the transistors, indicating their relative positions, are also shown. Note that transistors 8 and 30 are spaced away from one another at substantially right angles. However, this illustration is provided for example only and therefore a large number of other possibilities exists for separating these transistors and positioning other elements of the circuits shown.

A tenth preferred embodiment of the invention is illustrated in figure 4d. Here, n-channel transistors 22n and 24n are connected in the cross-coupling while p-channel transistors 30p and 32p are connected in series with the p-channel transistor of an associated inverter. This figure is the n-channel case of the drawing of figure 4b.

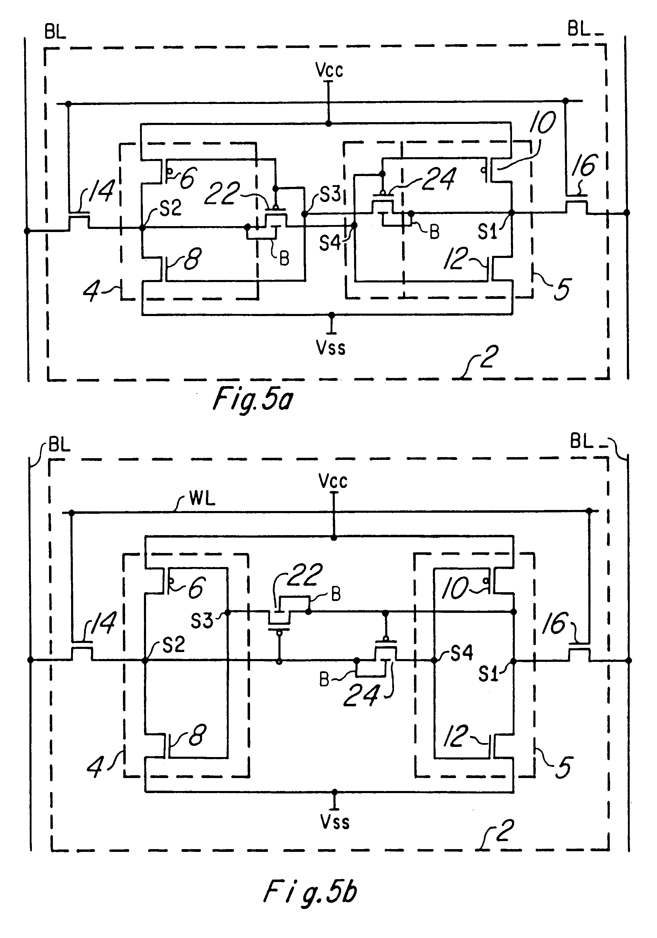

A schematic drawing of an integrated circuit which includes an eleventh preferred embodiment of invention is illustrated in figure 5a. Note that for optimum SEU hardness that this circuit is built on an insulator body (although it can be built on bulk semiconductor material) and therefore can be classified as a silicon on insulator (SOI) device. However, if bulit on bulk, near full benefit can be obtained if the devices in the cross-coupling are isolated from the bulk. Figure 5a illustrates the same circuit schematic as figure 1b with the exception that p-channel transistors 22 and 24 are connected across an associated cross-coupling line joining a gate of one inverter to the drain of another. The body of transistor 22 is tied to node S2 while the body of transistor 24 is tied to node S1. Additionally, the gate of transistor 22 is common with that of transistor 6 and the gate of transistor 24 is common with that of transistor 10.

Demonstration of the operation of the circuit in figure 5a shall be shown by example. Note that a capacitor exists comprising one plate formed by the gate of transistor 22 and a second plate which includes the body connection to node S2. Therefore, an energetic particle causing voltage change at node S2 due to an energetic particle generated charge at node S2 will initially result in approximately an equal amount of change an equal amount of change at the gate of transistor 22. Likewise, the gate of transistor 24 responds in a similar way with regard to energetic particle- caused voltage changes at node S1 in the capacitor comprised of one plate formed by the gate of transistor 24 and a second plate which includes the body connection to node S1.

Assume that node S2 is at a higher voltage potential than node S1, and that memory cell 2 is storing a logic high corresponding to binary one. Transistors 6, 12, and 22 are on while transistors 8, 10, and 24 are off. However, transistor 24 is able to provide a feedback path between inverters 4 and 5 through a gated diode provided by the structure of transistor 24 which will be explained further in this description. When the body of transistor 8 is hit by a critical-charge-generating energetic particle, such as a heavy ion, node S2 begins to drop in voltage. Through capacitive coupling, this lowers the voltage at node S3. Thus, in response to this lower voltage at node S3, transistor 6 turns on more strongly, raising the voltage at node S2 and allowing cell 2 to maintain its logic state. Should a charge -generating energetic particle hit the body of transistor 10, node S1 rises in voltage. However, this causes the voltage at node S4 to rise and causes transistor 12 to turn on stronger, thereby allowing cell 2 to recover from the hit. Likewise, assuming cell 2 is storing a zero with node S1 higher in voltage than node S2, (transistors 8, 10, and 24 on with transistors 6, 12 and 22 off) if an energetic particle hits the body of transistor 12, node S1 begins to drop in voltage. This lowers the voltage at node S4 of the capacitor formed by the gate of transistor 22 and the source/drain at node S1 of transistor 24. In response to the lowered voltage at node S4, transistor 10 turns on more strongly and raises the voltage at node S1, thus maintaining cell 2's logic state. As with transistor 24, transistor 22 is able to provide a feedback path between inverters 4 and 5 due to a gated diode structure provided by the structure of transistor 22 which will be discussed further in this description. If the body of transistor 6 is hit by a charge generating particle, node S2 rises in voltage. However, this raises the voltage at node S3. Therefore transistor 8 turns on more and allows charge to drain off node S2 thereby allowing memory cell 2 to recover from the hit.

Transistors 22 and 24 provide additional RC time constant delay which will further enable memory cell 2 to recover from a charge- generating energetic particle hit before the feedback mechamism latches the cell in the flipped state.

Figure 5b illustrates a schematic drawing of a twelfth preferred embodiment of the invention. This circuit is the same as that shown in figure 5a with the following exceptions: one drain/source of transistor 22 is connected to the common gate of inverter 4 while its other drain/source is connected to the common drain of inverter 5; the gate of transistor 22 is connected to the common drain of inverter 4; one drain/source of transistor 24 is connected to the common gate of inverter 5 while its other drain/source is connected to the common drain of inverter 4;the body of transistor 22 is connected to node S1; the body of transistor 24 is connected to node S2; and the gate of transistor 24 is connected to the common drain of inverter 5.

Demonstration of the operation of the circuit shown in figure 5b will be done by way of example. Assume that node S2 is at a higher voltage potential than node S1, and that memory cell 2 is storing a logic high corresponding to binary one. Transistors 8, and 22 are off and transistor 6 is on. When the body of transistor 8 is hit by an energetic particle, such as a heavy ion, node S2 begins to drop in voltage. Capacitive coupling lowers the voltage at node S3. Therefore transistor 6 turns on more strongly. Thus, node S2 rises in voltage, allowing memory cell 2 to recover from the hit. If the body of transistor 10 is hit by a charge generating energetic particle, node S1 rises in voltage. This correspondingly causes a rise in voltage at node S4 which turns transistor 12 on stronger. Thus, cell 2 is able to recover from the hit. Likewise, assuming cell 2 is storing a logic low with S1_ higher in voltage than S2, (transistors 8, 10 and 22 on with transistors 6, 12, and 24 off) if a critical charge generating energetic particle hits the body of transistor 12, node S1 begins to drop in voltage. If node S1 drops in voltage low enough, transistor 24 turns on, causing transistor 10 to turn on stronger. Thus the voltage at node S1 is raised and cell 2 is able to recover. Should the body of transistor 6 get hit by a charge generating energetic particle, node S2 rises in voltage causing node S3 to correspondingly rise in voltage. This causes transistor 8 to turn on stronger and drain the added charge off of node S2. Hence, cell 2 recovers from the hit.

As with the circuit in figure 5a, transistor 22 and 24 provide additional RC delay and feedback paths discussed previously in connection with figure 5a.

Note that the circuits shown in figures 5a and 5b both offer reduced SEU without substantial slowing of the memory write cycle. Additionally, a relatively high capacitance exists for SEU protection whether the channel is inverted or accumulated in transistors 22 or 24 of figures 5a and 5b.

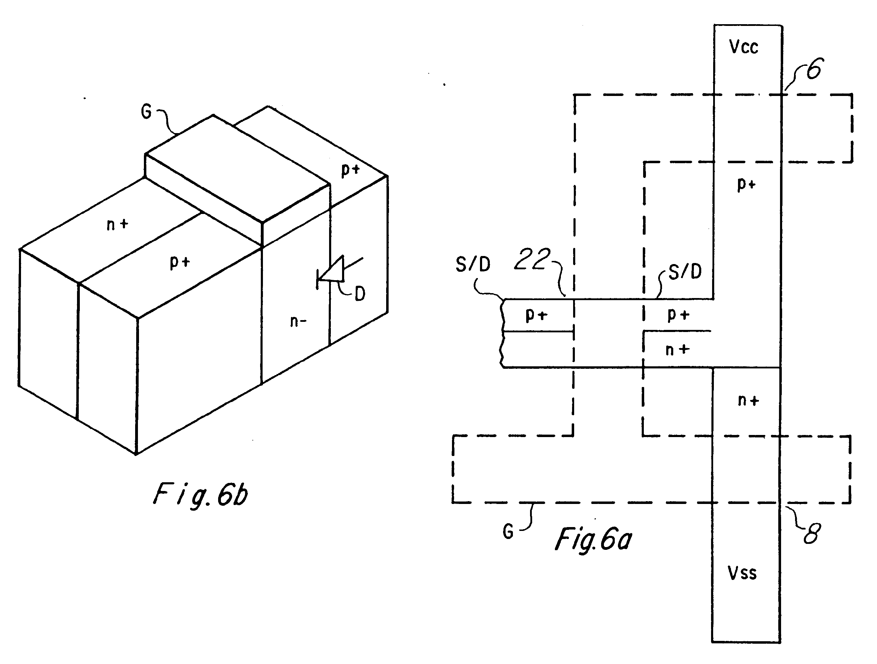

The gated diode structure of transistor 22 is illustrated in figure 6a which illustrates a top view of this structure. Gate G (shown in dotted lines) of transistor 22 is formed of polysilicon (or metal) and is common to the gates of transistors 6 and 8. P+ type and n+ type semiconductor regions are marked p+ and n+ respectively. The source of transistor 6 is labeled Vcc while the source of transistor 8 is labeled Vss so that both sources indicate their respective voltage potentials. Transistor 22's source/drain regions are labeled S/D. When transistor 22 is on gate voltage low), it functions as a typical field effect transistor. However, when transistor 22 is off (gate voltage high) it functions as a gated diode so as to maintain voltages in the cross-coupled inverter structure of a memory cell. Thus, a path for feedback primarily from p+ semiconductor region p+ under gate G to n+ semiconductor region n+ is provided by the diode function. In order to form a common node (such as node S2 shown in figure 5a), the adjacent n+ and p+ regions are connected by silicide. With respect to figure 5a, transistor 24's structure is similar to transistor 22 and can be visualized by relabeling transistor 6 as 10, transistor 22 as 24 and transistor 8 as 12. Figure 6b is a cross-sectional view of transistors 22 and 24 illustrating heavily doped n-type regions n+ (large concentration of donors) which will be silicided with abutting heavily doped p+ regions p+ (large concentration of acceptors). Also shown are body region n- and source/drain region labeled p+. A p-n diode D is formed as comprising source /drain region p+ and moat region n. Thus, when the cathode of diode D is at a sufficiently low voltage, current passes from region p+ to the adjacent silicided region of n+ and p+. Thus, for example, with reference to figure 5a, a logic low voltage at node S2 brings node S4 low even though node S3 is high.

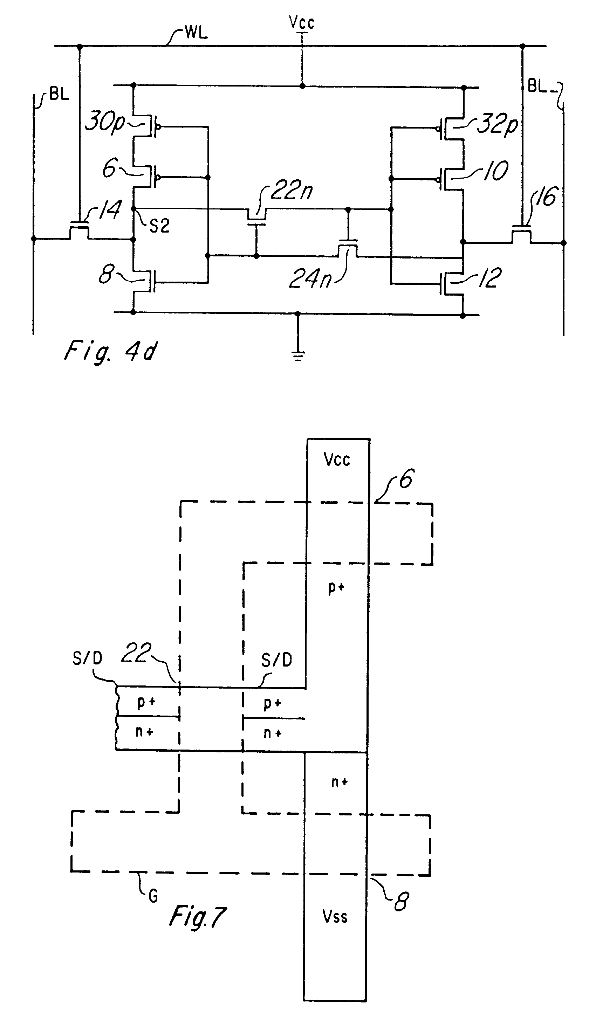

Note that the body contact B (body referring to the substrate portion of the transistor outside of the gate, source and drain) shown in figures 5a,5b, and 5a could have been placed on the opposite source/drain regions of transistors 22 and 24. Although this variation gives an extra capacitance benefit, the diode action does not maintain the cross-coupling path when transistors 22 or 24 are off.
A thirteenth preferred embodiment of the invention which increases memory cell speed with a little less SEU protection than the embodiment of figure 6a is shown in Figure 7. This figure is the same as figure 6a with the exception that adjacent n+ and p+ regions are added to both source/drain regions of transistor 22. Likewise, an adjacent n+ and p+ region may be added to both source drain regions of transistor 24 of figures 5a and 5b.

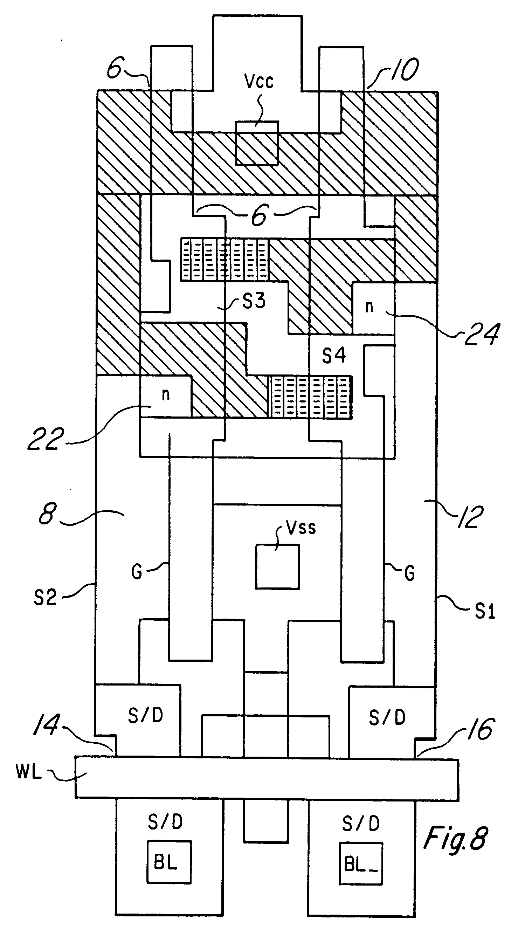

The layout Figure 8 illustrates the superposition of a plurality of portions of photolithographic masks so as to show an example of the physical layout of memory cell 2 and elements associated therewith. Figure 8 therefore shows these mask portions as they relate to what is shown in figure 5a. Positions for bit lines BL and BL_ are adjacent to one of two source/drain regions labeled S/D of transistors 14 and 16 respectively. The position of a common gate to transistors 14 and 16 is shown labeled word line WL. Other selected gate positions are labeled G. The positions of transistors 8 and 10 are indicated around the contact area labeled Vss (corresponding to the voltage Vss in figure 5a for this position) while the positions of transistors 6 and 10 are indicated around contact area Vcc (corresponding to the voltage Vcc in figure 5a for this position). P-type semiconductor areas are indicated by diagonal lines. The positions of transistors 22 and 24 are shown with each including the position of its p-type region and adjacent n-type region labeled n. The checkered areas show the positions of areas connected by local interconnect such as silicide to nodes S3 and S4. Transistors 22 and 24 can be enhancement p-channel transistors. Thus, no additional process or mask steps are required for their formation when making the memory cell and yet a high resistance is present in their channels. This aspect makes the memory cell even more hardened against SEU.

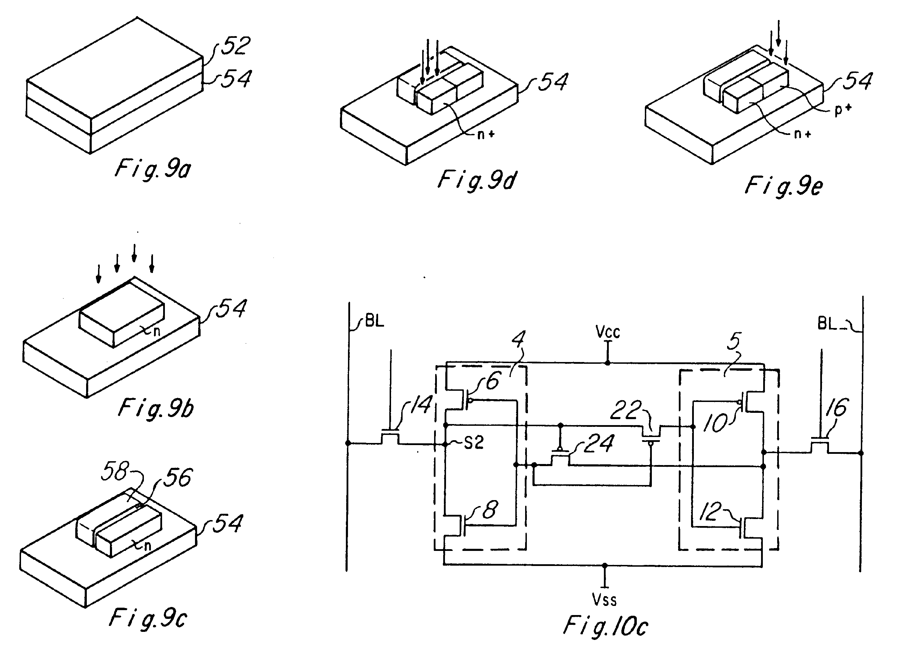

A brief overview of a possible fabrication process for making transistors 22 and 24, as they relate for example to that shown in figure 6a, omitting annealing steps and other sundry details which will be apparent, after reading the following description, to those skilled in the art, shall be described with reference to figures 9a through 9e which show cross-sectional views of the transistor structure during various stages of formation. Starting with a silicon 52 on insulator 54 (i.e. silicon dioxide) structure as shown in figure 9a, a mesa is etched as shown in figure 9b. A light donor n- is now implanted (shown by arrows). Next an oxide layer 56 is grown. Polysilicon gate 58 is then deposited and patterned (along with oxide layer 56, followed by a heavy masked doner implant (see n+ region under implant indicating arrows) and then followed by a heavy masked acceptor implant adjacent the n+ region to form two source/drain regions (see p+ region under implant indicating arrows). Note that one of the source/drain regions is not shown. Titanium (not shown) is sputtered over the n+ and p+ adjacent regions and sintered in a nitrogen ambient to form titanium silicide connections (not shown) between the n+ and p+ regions to form a common node.

It is to be understood that in order to conserve space in the memory cell that the transistors in the cross-coupling of the foregoing embodiments are metal oxide semiconductor (MOS) transistors.

A schematic drawing of an integrated circuit which includes a fourteenth preferred embodiment of the invention is illustrated in figure 10a. Note that for optimum SEU hardness that this circuit is built on an insulator (although it can be built on bulk semiconductor material) and therefore can be classified as an SOI device. Particular benefit is obtained if at least the devices in the cross-coupling are isolated from the bulk as could be done with stacked polysilicon transistors. Figure 10a illustrates the same circuit schematic as shown in figure 1b with the exception that p-channel transistors 22 and 24 are connected across an associated cross-coupling line joining a gate of one inverter to the drain of another. The gate of transistor 22 is connected to a source/drain of transistor 24 and the gate of transistor 24 is connected to the source/drain of transistor 22.

Demonstration of the operation of the circuit in figure 10a shall be shown by example. The p-channel nature of the depletion mode transistors 22, 24 increase their conductance with negative gate to source voltage and therefore the feedback mechanism for writing into the memory cell is not slowed significantly. For the case where node S1 is initially logic high and node S2 is initially logic low, when attempting to write the opposite state into memory cell 2, node S1 must first be pulled to logic low. This logic low transition must be transmitted through transistor 22 which is in its most turned on state, to the common gate of transistors 6 and 8. Node S2 then changes from its initial logic low state to a logic high state in response to a low voltage at the gates of transistors 6 and 8. However, the transition of node S2 from low to high is transmitted through transistor 24, the gate of which is now at a voltage causing transistor 24 to be in a higher conducting state (logic low). Note that while the WRITE is accomplished through transistors 22 and 24 in their most turned on state, the voltage maintaining feedback in memory cell 2 must always go through transistors 22 and 24, one of which is always in a lower conducting state (gate high). This feedback can alternatively be maintained by leakage or subthreshold current, meaning that enhancement mode transistors or depletion mode transistors can be used as transistors 22 and 24.

If transistors 6 or 10 are hit by a particle which changes the logic state at the output of an inverter, memory cell 2 is able to recover from the hit due to the added resistance provided in the cross-coupling by the resistive paths between source and drain regions of transistors 22 and 24 when each is in its lower conducting state. The effect of the added resistance increases the RC time constant delay, therefore preventing the negative effect of the SEU induced voltage change from propagating through memory 2. Because of the effect of the capacitance and the delay through the ON device, there will be substantial reduction of the SEU rate even for hits on the n-channel device. Therefore, the invention reduces the overall rate of SEU. An added advantage of this invention is that SEU rate reduction is provided without substantially effecting WRITE speed.

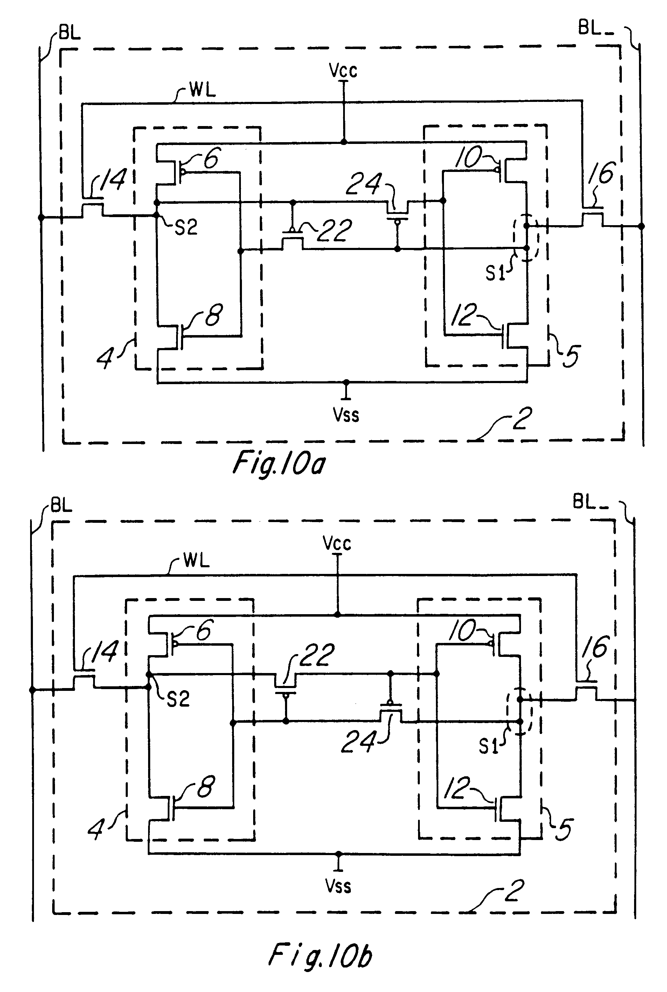

Figure 10b illustrates a schematic drawing of a fifteenth preferred embodiment of the invention. This circuit may be viewed as the same circuit shown in figure 10a with transistors 22 and 24 exchanged in position and numerical label with one another. The discussion of the operation of the circuit in figure 10a applies completely to the operation of the circuit in figure 10b by substituting transistor labels "22" with "24" and "24" with "22".

A sixteenth preferred embodiment of the invention connects the gate of transistor 24 to the input of inverter 4 as illustrated in figure 10c.

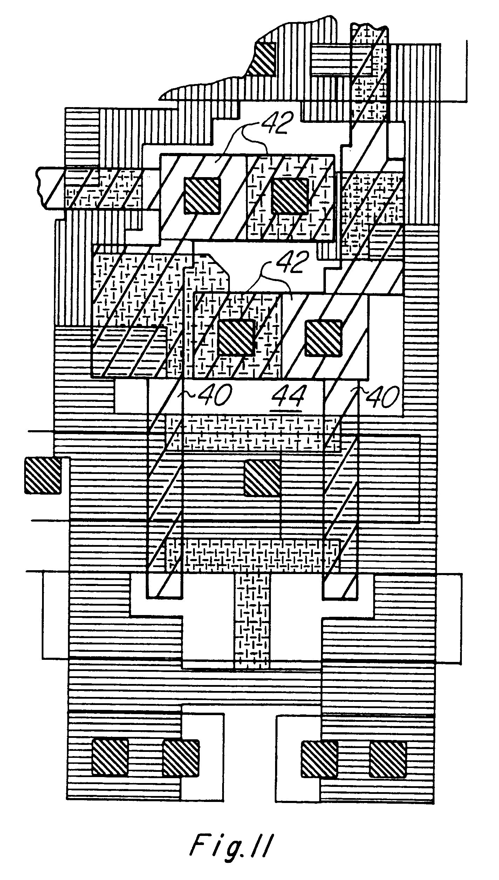

Figure 11 illustrates portions of superimposed photolithographic masks which give a layout scheme for constructing the foregoing described memory cell. Gate regions 40 (diagonally lined areas) are connected by straps 42 extending over moat region 44.

Although the invention has been described in detail herein with reference to its preferred embodiment and certain described alternatives, it is to be understood that this description is by way of example only, and is not to be construed in a limiting sense. It is to be further understood that numerous changes in the details of the embodiments of the invention, and additional embodiments of the invention, will be apparent to, and may be made by, persons of ordinary skill in the art having reference to this description. N-channel transistors may be substituted for the previously discussed p-channel transistors 22 and 24 in the cross coupling especially as long as writing into the memory cell is accomplished by pulling the low node high. While the requirements for resistance to SEU have focused on memory cells, this invention also applies to reducing the SEU susceptibility of a single latch. Also, p-channel transistors may be substituted with n-channel transistors. Further, transistors may be connected to the cross-coupling of inverters of a variety other than the CMOS inverters illustrated in the foregoing drawings. It is contemplated that all such changes and additional embodiments are within the scope of the invention as claimed below.

## Claims

1. A bi-stable logic device comprising:
a set of cross-coupled inverters (45), said set of inverters including first and second inverters and characterized by:
a pair of transistors (22, 24) each connected in one of the cross-couplings of the inverters so as to provide a time delay in effecting voltage changes by means of an impedance path in the respective cross-coupling, the gate of a first transistor of said pair being connected to a first source/drain of a second transistor of said pair in addition to the gate of said second transistor of said pair being connected to a first source/drain of said first transistor.

2. A bi-stable logic device as claimed in claim 1, and wherein each inverter includes a n-channel transistor and a p-channel transistor.

3. A bi-stable logic device as claimed in claim 2, and including a device (R1, R2) connected to and between the drains of said p-channel and n-channel transistors of at least one inverter, said device being capable of providing at least a selected level of impedance between said drains of said p-channel and n-channel transistors.

4. A bi-stable logic device as claimed in claim 1, claim 2 or claim 3, and wherein a second source/drain of said first transistor of said pair is connected to the input of said first inverter and wherein said first source/drain of said first transistor of said pair is connected to the output of said second inverter.

5. A bi-stable logic device as claimed in claim 4 and wherein said second source/drain of said second transistor of said pair is connected to said input of said second inverter and wherein said first source/drain of said second transistor of said pair is connected to said output of said first inverter.

6. A bi-stable logic device as claimed in claim 1, claim 2 or claim 3, and wherein a second source/drain of said first transistor of said pair is connected to the output of said first inverter and wherein said first source/drain of said first transistor of said pair is connected to the input of said second inverter.

7. A bi-stable logic device as claimed in claim 6, wherein a second source/drain of said second transistor is connected to said output of said second inverter and wherein said first source/drain of said second transistor of said pair is connected to said input of said first inverter.

8. A bi-stable logic device as claimed in any preceding claim, and wherein said transistors are metal oxide semiconductor transistors.

9. A bi-stable logic device as claimed in claim 3 or any of claims 4 to 8 in that they depend from claim 3, and wherein said device is a resistor.

10. A bi-stable logic device as claimed in claim 3 or any of claims 4 to 8 in that they depend from claim 3, and wherein said device is a transistor (8, 12).

11. A bi-stable logic device as claimed in any preceding claim, and including a diode connected in parallel with a transistor of said pair.

12. A bi-stable logic device as claimed in claim 11 and wherein said diode is connected to said first and second inverters such that the anode of said diode is connected to the input of said first inverter and the cathode of said first diode is connected to the output of said second inverter.

13. A bi-stable logic device as claimed in claim 12, wherein said first transistor includes a body region, said body region being connected to the output of said first inverter.

14. A bi-stable logic device as claimed in claim 12 or claim 13, wherein said second transistor includes a body region, said body region of said second transistor being connected to the output of said second inverter.

15. A bi-stable logic device as claimed in claim 12, 13, or 14, wherein a first source/drain of said first transistor includes a structure comprising a n-type semiconductor region abutting a p-type semiconductor region.

16. A bi-stable logic device as claimed in claim 17, wherein said n-type and p-type abutting regions are connected with a conductive material.

17. A bi-stable logic state device as claimed in any of claims 12 to 16, and wherein a second source/drain of said second transistor includes a structure comprising a n-type semiconductor region abutting a p-type semiconductor region.

18. A bi-stable logic state device as claimed in claim 17, wherein said n-type and p-type abutting regions of said second source/drain are connected with a conductive material.

19. A bi-stable logic device as claimed in any preceding claim, and wherein said bi-stable device is formed on a thin film of semiconductor material overlying an insulator (54).

## Patentansprüche

1. Bistabile Logikschaltung, enthaltend:
eine Gruppe kreuzweise gekoppelter Inverter (45), wobei die Invertergruppe erste und zweite Inverter enthält, gekennzeichnet durch:
ein Paar Transistoren (22, 24), von denen jeweils einer in einer der Kreuzkopplungen der Inverter angeschlossen ist, so daß eine Zeitverzögerung beim Hervorrufen von Spannungsänderungen mittels eines Impedanzwegs in der jeweiligen Kreuzkopplung geschaffen wird, wobei das Gate eines ersten Transistors des Paars mit einem Source/Drain-Anschluß eines zweiten Transistors des Paars und überdies das Gate dieses zweiten Transistors des Paars mit einem ersten Source/Drain-Anschluß des ersten Transistors verbunden ist.

2. Bistabile Logikschaltung nach Anspruch 1, bei welcher jeder Inverter einen N-Kanal-Transistor und einen P-Kanal-Transistor enthält.

3. Bistabile Logikschaltung nach Anspruch 2 mit einer Vorrichtung (R1, R2), die an den Drain-Anschlüssen der P-Kanal- und N-Kanal-Transistoren wenigstens eines Inverters verbunden sind und zwischen diesen Drain-Anschlüssen liegen, wobei die Vorrichtung wenigstens einen ausgewählten Impedanzwert zwischen den Drain-Anschlüssen der P-Kanal- und N-Kanal-Transistoren erzeugen kann.

4. Bistabile Logikschaltung nach Anspruch 1, Anspruch 2 oder Anspruch 3, bei welcher ein zweiter Source/Drain-Anschluß des ersten Transistors des Paars mit dem Eingang des ersten Inverters verbunden ist und bei welcher der erste Source/Drain-Anschluß des ersten Transistors des Paars mit dem Ausgang des zweiten Inverters verbunden ist.

5. Bistabile Logikschaltung nach Anspruch 4, bei welcher der zweite Source/Drain-Anschluß des zweiten Transistors des Paars mit dem Eingang des zweiten Inverters verbunden ist und bei welcher der erste Source/Drain-Anschluß des zweiten Transistors des Paars mit dem Ausgang des ersten Inverters verbunden ist.

6. Bistabile Logikschaltung nach Anspruch 1, Anspruch 2 oder Anspruch 3, bei welcher ein zweiter Source/Drain-Anschluß des ersten Transistors des Paars mit dem Ausgang des ersten Inverters verbunden ist und bei welcher der erste Source/Drain-Anschluß des ersten Transistors des Paars mit dem Eingang des zweiten Inverters verbunden ist.

7. Bistabile Logikschaltung nach Anspruch 6, bei welcher ein zweiter Source/Drain-Anschluß des zweiten Transistors mit dem Ausgang des zweiten Inverters verbunden ist und bei welcher der erste Source/Drain-Anschluß des zweiten Transistors des Paars mit dem Eingang des ersten Inverters verbunden ist.

8. Bistabile Logikschaltung nach einem der vorhergehenden Ansprüche, bei welcher die Transistoren Metall-Oxid-Halbleiter-Transistoren sind.

9. Bistabile Logikschaltung nach Anspruch 3 oder einem der Ansprüche 4 bis 8 bei Abhängigkeit vom Anspruch 3, bei welcher die Vorrichtung ein Widerstand ist.

10. Bistabile Logikschaltung nach Anspruch 3 oder einem der Ansprüche 4 bis 8 bei Abhängigkeit vom Anspruch 3, bei welcher die Vorrichtung ein Transistor (8, 12) ist.

11. Bistabile Logikschaltung nach einem der vorhergehenden Ansprüche mit einer Diode, die parallel zu einem Transistor des Paars geschaltet ist.

12. Bistabile Logikschaltung nach Anspruch 11, bei welcher die Diode so mit dem ersten und zweiten Inverter verbunden ist, daß die Anode oder Diode mit dem Eingang des ersten Inverters und die Kathode der ersten Diode mit dem Ausgang des zweiten Inverters verbunden ist.

13. Bistabile Logikschaltung nach Anspruch 12, bei welcher der erste Transistor eine Körperzone enthält, wobei die Körperzone mit dem Ausgang des ersten Inverters verbunden ist.

14. Bistabile Logikschaltung nach Anspruch 12 oder Anspruch 13, bei welcher der zweite Transistor eine Körperzone enthält, wobei die Körperzone des zweiten Transistors mit dem Ausgang des zweiten Inverters verbunden ist.

15. Bistabile Logikschaltung nach Anspruch 12, 13 oder 14, bei welcher ein erster Source/Drain-Anschluß des ersten Transistors eine Struktur enthält, die eine an eine p-leitende Halbleiterzone anstoßende n-leitende Halbleiterzone umfaßt.

16. Bistabile Logikschaltung nach Anspruch 17, bei welcher die aneinanderstoßenden n- und p-leitenden Zonen mit einem leitenden Material verbunden sind.

17. Bistabile Logikschaltung nach einem der Ansprüche 12 bis 16, bei welcher ein zweiter Source/Drain-Anschluß des zweiten Transistors eine Struktur enthält, die eine an eine p-leitende Halbleiterzone anstoßende n-leitende Halbleiterzone umfaßt.

18. Bistabile Logikschaltung nach Anspruch 17, bei welcher die aneinanderstoßenden n- und p-leitenden Zonen des zweiten Source-Drain-Anschlusses mit einem leitenden Material verbunden sind.

19. Bistabile Logikschaltung nach einem der vorhergehenden Ansprüche, bei welcher die bistabile Vorrichtung auf eine dünnen Schicht aus Halbleitermaterial gebildet ist, die über einem Isolator (54) liegt.

## Revendications

1. Dispositif logique bistable comprenant :
un ensemble d'inverseurs (45) couplés en croix, ledit ensemble d'inverseurs comportant des premier et second inverseurs et caractérisé en ce qu'il comporte :
une paire de transistors (22,24) reliés chacun à un des couplages en croix des inverseurs de manière à fournir un temps de retard lors de la réalisation de changements de tension au moyen d'un trajet d'impédance dans le couplage en croix respectif, la grille d'un premier transistor de ladite paire étant reliée à une première source/drain d'un second transistor de ladite paire, la grille dudit second transistor de ladite paire étant en outre reliée à une première source/drain dudit premier transistor.

2. Dispositif logique bistable selon la revendication 1, et dans lequel chaque inverseur comporte un transistor un canal (n) et un transistor à canal (p).

3. Dispositif logique bistable selon la revendication 2, et comportant un dispositif (R1,R2) relié au drain desdits transistors à canal (p) et à canal (n) d'au moins un inverseur, et entre ceux-ci, ledit dispositif étant adapté pour fournir au moins un niveau sélectionné d'impédance entre lesdits drains desdits transistors à canal (p) et à canal (n).

4. Dispositif logique bistable selon la revendication 1, la revendication 2, ou la revendication 3, et dans lequel une seconde source/drain dudit premier transistor de ladite paire est reliée à l'entrée dudit premier inverseur et dans lequel ladite première source/drain dudit premier transistor de ladite paire est reliée à la sortie dudit second inverseur.

5. Dispositif logique bistable selon la revendication 4, et dans lequel ladite seconde source/drain dudit second transistor de ladite paire est reliée à ladite entrée dudit second inverseur et dans lequel ladite première source/drain dudit second transistor de ladite paire est reliée à ladite sortie dudit premier inverseur.

6. Dispositif logique bistable selon la revendication 1, la revendication 2, ou la revendication 3, et dans lequel une seconde source/drain dudit premier transistor de ladite paire est reliée à la sortie dudit premier inverseur et dans lequel ladite première source/drain dudit premier transistor de ladite paire est reliée à l'entrée dudit second inverseur.

7. Dispositif logique bistable selon la revendication 6, dans lequel une seconde source/drain dudit second transistor est reliée à ladite sortie dudit second inverseur et dans lequel ladite première source/drain dudit second transistor de ladite paire est reliée à ladite entrée dudit premier inverseur.

8. Dispositif logique bistable selon l'une quelconque des revendications précédentes, et dans lequel lesdits transistors sont des transistors semiconducteurs à grille isolée par oxyde métallique.

9. Dispositif logique bistable selon la revendication 3 ou selon l'une quelconque des revendications 4 à 8 dépendantes de la revendication 3, et dans lequel ledit dispositif est une résistance.

10. Dispositif logique bistable selon la revendication 3 ou selon l'une quelconque des revendications 4 à 8 dépendantes de la revendication 3, et dans lequel ledit dispositif est un transistor (8,12).

11. Dispositif logique bistable selon l'une quelconque des revendications précédentes, et comportant une diode reliée en parallèle sur un transistor de ladite paire.

12. Dispositif logique bistable selon la revendication 11, et dans lequel ladite diode est reliée auxdits premier et second inverseurs de telle sorte que l'anode de ladite diode est reliée à l'entrée dudit premier inverseur et la cathode de ladite première diode est reliée à la sortie dudit second inverseur.

13. Dispositif logique bistable selon la revendication 12, dans lequel ledit premier transistor comporte une zone formant corps, ladite zone formant corps étant reliée à la sortie dudit premier inverseur.

14. Dispositif logique bistable selon la revendication 12 ou la revendication 13, dans lequel ledit second transistor comporte une zone formant corps, ladite zone formant corps dudit second transistor étant reliée à la sortie dudit second inverseur.

15. Dispositif logique bistable selon la revendication 12, 13 ou 14, dans lequel une première source/drain dudit premier transistor comporte une structure comprenant une zone à semiconducteur de type n s'appuyant contre une zone à semiconducteur de type p.

16. Dispositif logique bistable selon la revendication 17, dans lequel lesdites zones d'appui de type n et de type p sont reliées à un matériau conducteur.

17. Dispositif logique bistable selon l'une quelconque des revendications 12 à 16, et dans lequel une seconde source/drain dudit second transistor comporte une structure comprenant une zone à semiconducteur de type n s'appuyant contre une zone à semiconducteur de type p.

18. Dispositif logique bistable selon la revendication 17, dans lequel lesdites zones d'appui de type n et de type p de ladite seconde source/drain sont reliées à un matériau conducteur.

19. Dispositif logique bistable selon l'une quelconque des revendications précédentes, et dans lequel ledit dispositif bistable est formé sur un film mince de matériau semiconducteur recouvrant un isolant (54).
